# EUROPEAN PATENT APPLICATION

(11) **EP 4 317 522 A1**
(43) Date of publication of application: **07.02.2024**
(21) Application number: 22775428.0
(22) Date of filing: 17.03.2022
(51) Int. Cl.: C23C 14/08, C01G 41/00, C23C 14/34

(54) **TRANSPARENT CONDUCTIVE FILM, METHOD FOR PRODUCING TRANSPARENT CONDUCTIVE FILM, TRANSPARENT CONDUCTIVE MEMBER, ELECTRONIC DISPLAY DEVICE, AND SOLAR BATTERY**

(30) Priority: 22.03.2021 JP 2021047555
(71) Applicant: SUMITOMO METAL MINING CO., LTD., Tokyo 105-8716 (JP)
(72) Inventor: ADACHI, Kenji, Ichikawa-shi, Chiba 272-8588 (JP); SATO, Keiichi, Isa-shi, Kagoshima 895-2501 (JP); OGAMI, Hideharu, Tokyo 105-8716 (JP); YOSHIO, Satoshi, Niihama-shi, Ehime 792-0001 (JP)
(74) Representative: Jones, Nicholas Andrew
(86) International application number: PCT/JP2022/012476
(87) International publication number: WO 2022/202640

(57) **Abstract**

A transparent conductive film containing an alkali tungsten bronze is provided. The alkali tungsten bronze exhibits a pattern of a hexagonal crystal as a powder X-ray diffraction pattern and is free of shift to an orthorhombic crystal, a trigonal crystal, and a pyrochlore phase.

## Description

### TECHNICAL FIELD

The present invention relates to a transparent conductive film, a method for producing a transparent conductive film, a transparent conductive member, an electronic display device, and a solar battery.

### BACKGROUND OF THE INVENTION

Transparent conductive films are used as, for example, transparent electrodes of, for example, liquid crystal display elements and solar batteries, infrared absorption/reflection films, and electromagnetic shielding films. Particularly, liquid crystal display elements are proactively employed in OA equipment such as personal computers and word processors, and demand for transparent electrodes is increasing accordingly. Indium-Tin-Oxide (ITO) obtained by doping indium oxide with some percent by mole of tin is mainly used as transparent electrodes for liquid crystal display elements, because ITO materially contains abundant conduction electrons (free electrons), is highly conductive, and can be patterned relatively easily by etching (see Patent Documents 1 and 2, and Non-Patent Document 1).

In₂O₃, the pristine phase of ITO, is an oxide semiconductor, and is a transparent conductive material that exhibits conductivity by being supplied with carrier electrons through introduction of oxygen defects into the crystal. It is considered that In₂O₃ will exhibit high conductivity when Sn is added because carrier electrons will increase further as trivalent In sites are replaced by tetravalent Sn.

Recent years' liquid crystal display devices are in tendencies toward a larger area, a greater number of pixels, a higher definition, and lower costs. In order to obtain liquid crystal display units free of display failures and having high image qualities, it is desirable to improve performances of transparent electrodes, particularly, to increase visible light transmittance and reduce film surface resistance (also referred to as sheet resistance), and a reduction of the costs of transparent electrodes themselves is an issue of critical importance.

ITO conductive films have excellent visible light transmittance and film surface resistance, but are expensive because indium is used. Hence, transparent conductive films have been worked for physical property improvement and cost reduction by, for example, improvement of ITO film formation techniques and improvement of sputtering targets. However, ITO has physical property limits, and it is getting to be more difficult to accommodate the more advanced needs of recent years.

Zinc oxide doped with some percent by mole of Al or Ga (AZO or GZO) is one candidate transparent conductive material to replace ITO. AZO or GZO is supplied with carrier electrons through replacement of divalent Zn sites by trivalent Al or Ga, to serve as a transparent conductive material having high conductivity. AZO or GZO has been considered the principal candidate material to replace ITO, as they have transparent conductivity close to that of ITO. However, drawbacks of AZO or GZO are narrow ranges of conditions under which they exhibit conductivity, and considerably poor heat resistance and weather resistance compared with those of ITO (Non-Patent Document 1).

Tin oxide is a material traditionally known as a transparent conductive material to replace ITO. Tin oxide has chemical and thermal stability and visible light transmittance better than those of ITO, and is hence used as, for example, electrodes for solar batteries. However, tin oxide has a conductivity considerably lower than that of ITO, even if its specific resistance is reduced by antimony doping or partial replacement of oxygen with fluorine. Moreover, tin oxide has poor etchability. Hence, tin oxide is not used as electrodes for displays (Non-Patent Document 1) .

The applicant has proposed a transparent conductive film formed of tungsten oxide represented by general formula: W_{y}O_{z} (2.2<z/y<2.999) or a complex tungsten oxide represented by general formula: MₓW_{y}O_{z} (see Patent Document 3). The element M in the complex tungsten oxide is one or more elements selected from, for example, H, He, alkali metals, alkaline-earth metals, rare-earth elements, and other transition metals. The complex tungsten oxide satisfies 0.001≤x/y≤1 and 2.2≤z/y≤3.0.

Patent Document 3 also discloses a method of producing a transparent conductive film, which produces the mentioned transparent conductive film by applying a solution containing a raw material compound, which is any or all selected from tungsten oxide, a complex tungsten oxide, and a complex oxide, to a base material, and then thermally treating the resulting product in an atmosphere of either or both of a reducing gas and an inert gas.

Patent Document 4 discloses a technique relating to an infrared shielding film, which uses a complex tungsten oxide film formed by a sputtering method.

However, when formed by a sputtering method, conductive films of tungsten oxide or a complex tungsten oxide mentioned above tend to have extremely high electrical resistance values, which may be specific resistance values of 10² Qcm or higher typically, or may be resistance values on the order of 10⁻² Qcm level at the minimum. Hence, transparent conductive films of tungsten oxide or a complex tungsten oxide formed by a sputtering method overwhelmingly lack in conductivity necessary as transparent conductive films.

A value of 5.5×10⁻⁵ Qcm has been reported as a room-temperature specific resistance of a single crystal of Cs_{0.32}WO₃ having a hexagonal tungsten bronze crystal structure (Non-Patent Document 2). However, this potentially high conductivity has not been realized in the form of dry thin films.

As described above, transparent conductive films of tungsten oxide or a complex tungsten oxide have been proposed as one candidate transparent conductive film to replace ITO. However, typical dry methods for producing continuous films, which are represented by a sputtering method, have not found a transparent conductive film having a high conductivity indicated by a specific resistance of lower than 5.2×10⁻² Qcm.

Accordingly, a new transparent conductive film having a high conductivity has been needed.

### RELATED-ART DOCUMENT

### Patent Document

[Patent Document 1]
   Japanese Patent Application Laid-Open No. 2003-249125
[Patent Document 2]
   Japanese Patent Application Laid-Open No. 2004-026554
[Patent Document 3]
   Japanese Patent Application Laid-Open No. 2006-096656
[Patent Document 4]
   Japanese Patent Application Laid-Open No. 2019-196521

### Non-Patent Document

[Non-Patent Document 1]
   Edited by Japan Society for the Promotion of Science, "Toumei Douden Maku no Gijutsu (Techniques for Transparent Conductive Films)", Ohmsha, Ltd., 2006, 2nd revision, (pp.153-173)
[Non-Patent Document 2]
   M. R. Skokan, W. G. Moulton, and R. C. Morris, Normal and superconducting properties of CsxWO3, Phys. Rev. B 20 (1979) 3670 -3677
[Non-Patent Document 3]
   S. Oshio, M. Yamamoto, J. Kuwata, and T. Matsuoka, Interaction of reactively sputtered TaOx thin films with In-Sn-O thin films and properties of TaOx thin films, J. Appl. Phys. 71, 3471 (1992).

### SUMMARY OF THE INVENTION

### Problems to be Solved by the Invention

In view of the existing techniques' problems, an object according to an aspect of the present invention is to provide a transparent conductive film having excellent conductivity.

### Means for Solving the Problems

According to an aspect of the present invention, provided is a transparent conductive film containing an alkali tungsten bronze, wherein the alkali tungsten bronze exhibits a pattern of a hexagonal crystal as a powder X-ray diffraction pattern, and is free of shift to an orthorhombic crystal, a trigonal crystal, and a pyrochlore phase.

### Effects of the Invention

According to an aspect of the present invention, a transparent conductive film having excellent conductivity can be provided.

### BRIEF DESCRIPTION OF THE DRAWINGS

[FIG. 1]

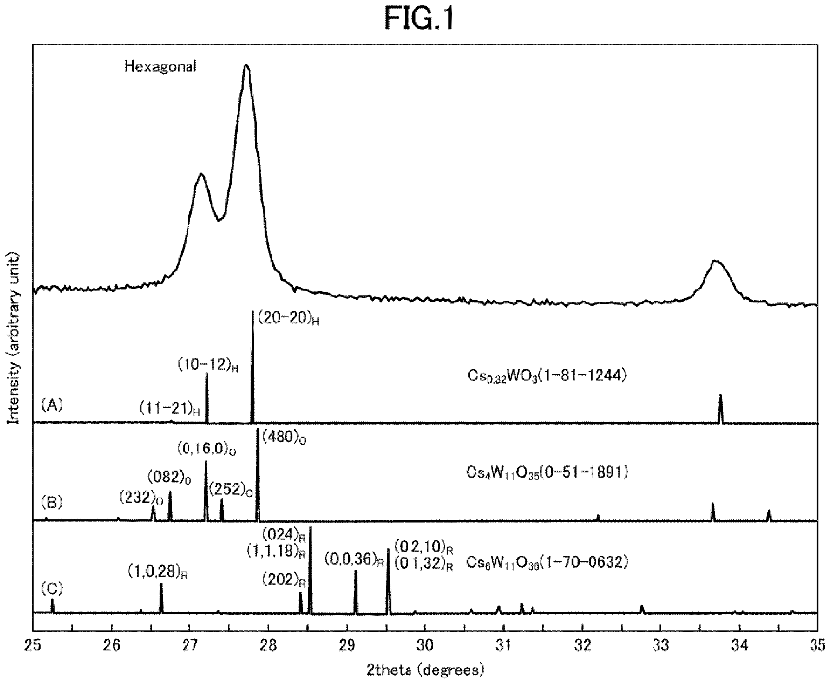

   FIG. 1 is a powder X-ray diffraction pattern of a transparent conductive film obtained in Example 1.
[FIG. 2]

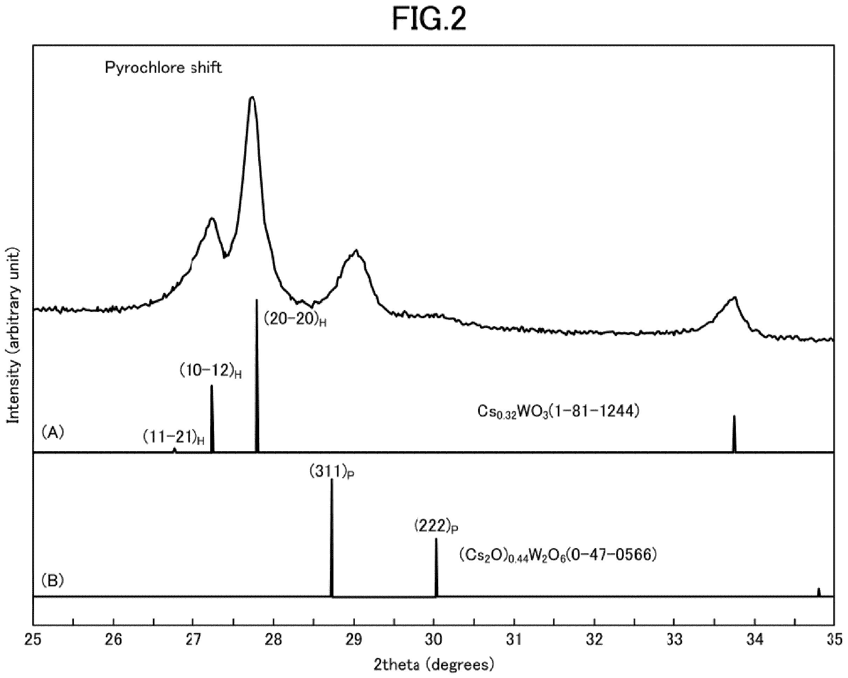

   FIG. 2 is a powder X-ray diffraction pattern of a film obtained in Comparative Example 3.

### DETAILED DESCRIPTION OF THE INVENTION

Specific examples of a transparent conductive film, a method for producing a transparent conductive film, a transparent conductive member, an electronic display device, and a solar battery according to an embodiment (hereinafter, denoted as "the present embodiment") of the present disclosure will be described below with reference to the drawings. The present invention is not limited to these examples, and is intended to be defined by claims and include all modifications that are within the meaning and scope equivalent to the claims.

In the notation of Miller indices, it is stipulated that a negative index should be represented by a number topped with a bar (-). However, in the following description, a number will be preceded by a negative sign (-). When a two-digit index is included among indices, "," will be interposed between the indices. A suffix "H" represents a hexagonal crystal. A suffix "O" represents an orthorhombic crystal. A suffix "R" represents a trigonal crystal. A suffix "P" represents a pyrochlore phase. Two planes, reflections from which coincide with each other at the same diffraction angle, will be represented with "/" interposed between the Miller indices indicating the respective planes.

### [Transparent conductive film]

As a material of a transparent conductive film, the present inventors have focused attention on tungsten bronze, which is a material that: takes advantage of the skeletal structure of tungsten trioxide, which is a wide-bandgap material to transmit light in the visible light range; and possesses conduction electrons produced by reduction in the amount of oxygen and addition of cations. Then, as a result of earnest studies, the present inventors have expected that, among various types of tungsten bronzes, alkali tungsten bronze (complex alkali tungsten oxide) with a hexagonal crystal structure has a high visible light transmittance and is the most promising as a complex tungsten oxide or a transparent conductive film.

However, according to the present inventors' studies, amorphous films, which often result from dry film formation under hitherto employed typical conditions using a film formation source such as a sputtering target containing an alkali metal element and tungsten, have failed to form a hexagonal tungsten bronze structure even though crystallized by thermal treatment. Likewise, a hexagonal tungsten bronze has not been formed through crystallization performed immediately after film formation, by, for example, raising the substrate temperature. These films formed have failed to have high conductivity to serve as transparent conductive films, although they have a high visible light transmittance.

It has been confirmed, by structural analyses of the thin films formed by the dry film formation method described above, that the thin films are a polytungstate having an orthorhombic structure, a trigonal structure, or a cubic pyrochlore structure, where the lattice cavity sites are partly intruded by, for example, water, oxygen, and OH ions. That is, the complex alkali tungsten oxide thin films obtained by the dry film formation method described above do not have the normal hexagonal tungsten bronze structure.

Hitherto, powder X-ray diffraction patterns measured from complex alkali tungsten oxide thin films have been identified to belong to hexagonal crystal patterns. However, when it comes to powder X-ray diffraction patterns of complex alkali tungsten oxide thin films, diffraction patterns that indicate a slight shift to an orthorhombic crystal, a trigonal crystal, and a pyrochlore phase, have also been identified as the same hexagonal crystal patterns.

Here the orthorhombic crystal is actually a structure having a stacking fault on the prismatic plane of hexagonal crystal, which reduces to an orthorhombic Cs₄W₁₁O₃₅ when faults are introduced regularly. The trigonal crystal and a cubic pyrochlore phase are structures having a stacking fault on the basal plane of hexagonal crystal, which reduces to a trigonal Cs₆W₁₁O₃₆, a trigonal Cs_{8.5}W₁₅O₄₈, and a pyrochlore-phase (Cs₂O)_{0.44}W₂O₆ when faults are introduced at respective regularities.

Normal hexagonal tungsten bronze films exhibit peaks of maximum intensities of (20-20)_{H} and (10-12)_{H} reflections at a diffraction angle around 2θ=27.5° in powder X-ray diffraction patterns. However, a fine inspections, weak diffraction lines are observed in many of the actual thin films at angles smaller or larger than the angles corresponding to these two peaks, which are attributable to the orthorhombic or trigonal crystal, or the cubic pyrochlore phase. That is, the hexagonal Cs_{0.32}WO₃ tends to have planar defects on the basal and prismatic planes. The orthorhombic Cs₄W₁₁O₃₅ is produced in relation with a planar defect on the prismatic plane, whereas the trigonal Cs₆W₁₁O₃₆ or Cs_{8.5}W₁₅O₄₈, and the pyrochlore-phase (Cs₂O)_{0.44}W₂O₆ are produced in relation with a planar defect on the basal plane.

FIG. 1 and FIG. 2 indicate primary diffraction peaks at 20 from 25° through 35°. The topmost level of FIG. 1 indicates a powder X-ray diffraction pattern of a hexagonal tungsten bronze film obtained in Example 1 described below.

(A) to (C) of FIG. 1 indicate data from a powder X-ray diffraction pattern database. (A) of FIG. 1 indicates a profile of hexagonal Cs_{0.32}WO₃, (B) indicates a profile of orthorhombic Cs₄W₁₁O₃₅, and (C) indicates a profile of trigonal Cs₆W₁₁O₃₆.

The topmost level of FIG. 2 illustrates a powder X-ray diffraction pattern of a film having a pyrochlore phase shift (pyrochlore shift) obtained in Comparative Example 3 described below. (A) of FIG. 2 illustrates a profile of hexagonal Cs_{0.32}WO₃, and (B) illustrates a profile of pyrochlore-phase (Cs₂O)_{0.44}W₂O₆.

When a hexagonal crystal shifts to a direction toward orthorhombic Cs₄W₁₁O₃₅, (0,16,0)_{O} and (480)_{O} increase the apparent peak width of (10-12)_{H} and (20-20)_{H}, respectively, and weak peaks of (252)_{O}, (082)_{O}, and (232)_{O} emerge at angles smaller than the angle corresponding to (20-20)_{H}.

When a hexagonal crystal shifts to a direction toward trigonal Cs₆W₁₁O₃₆, diffraction lines from (024)_{R}/(1,1,18)_{R}, (0,2,10)_{R}/(0,1,32)_{R}, (202)_{R}, and (0,0,36)_{R} weakly appear at angles larger than the angle corresponding to (20-20)_{H}.

When a hexagonal crystal shifts to a direction toward cubic pyrochlore-phase (Cs₂O)_{0.44}W₂O₆, weak diffraction lines from (311)_{P} and (222)_{P} appear at angles larger than the angle corresponding to (20-20)_{H}.

However, there are cases where the intensity distribution of these extra diffraction lines and the positions of the diffraction lines are offset from the positions and intensities of the diffraction lines of the orthorhombic crystal, the trigonal crystal, and the pyrochlore phase in the data base. This suggests that the orthorhombic crystal, the trigonal crystal, and the pyrochlore phase that seem to co-exist with a hexagonal crystal might actually be not separate crystal phases simply mixed, but stacking faults involved in one hexagonal crystal, produced on different planes by different amounts, according to which powder X-ray diffraction patterns were varied

The present inventors have found that this phenomenon, i.e., the appearance of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of a hexagonal crystal is fundamentally due to an existence of water, which is introduced into the film during vacuum film deposition.

In a typical dry film deposition, a lot of residual water is contained on the internal walls of the vacuum film formation chamber and the target itself contain a lot of residual water, to say nothing of a supplied gas such as Ar or O₂. Hence, during a surface condensation process in which molecules and atoms come flying onto the substrate on which the film is formed, many ions derived from water molecules and water, such as O²⁻, OH⁻, H₃O⁺, and H⁺, are incorporated into the film (Non-Patent Document 3). Although hydrogen derived from water binds with oxygen contained in the crystal, because it competes with alkali metal element ions such as Cs⁺ and with W⁶⁺ contained in the crystal, cationic element defects such as W defects and Cs defects on the basal plane and prismatic plane of a hexagonal crystal occur under the charge neutrality condition. The present inventors have found that the spacing between planes on which W defects and Cs defects occur slightly expands because ionic repulsion occurs locally in these planes. This expansion breaks the hexagonal symmetry of the crystal, which hence leads to symmetry changes to an orthorhombic crystal, a trigonal crystal, or a cubic crystal.

Various molecules derived from water such as O, OH, OH₂, and H₃O remain in orthorhombic polytungstates, trigonal polytungstates, and alkali pyrochlore structures, and are taken into relatively large cavities in the crystal, such as hexagonal cavities, hexagonal windows, and pyrochlore cavities.

When the aforementioned complex tungsten oxide thin film by dry film formation under hitherto employed typical conditions is subjected to a reductive thermal treatment after film formation, oxygen that composes the WO₆ octahedral skeleton is reduced. Bound electrons W⁵⁺ that are introduced to the W cations by these oxygen vacancies significantly absorb near infrared light through the hopping migration in crystal. The present inventors' studies have revealed that conductivity is extremely low either because there exist very few free electrons or because all electrons are bound electrons. Accordingly, by removing water during film formation, which constitutes the cause of all of these, it is possible to obtain true hexagonal tungsten bronze as originally intended, and to obtain high electrical conductivity and near-infrared reflection attributable to numerous free electrons contained in this material.

Hence, the transparent conductive film according to the present embodiment contains an alkali tungsten bronze, and the alkali tungsten bronze can have a structure that exhibits a pattern of a hexagonal crystal as a powder X-ray diffraction pattern and is free of shift to an orthorhombic crystal, a trigonal crystal, and a pyrochlore phase. That is, it is preferable that ions of, for example, O, OH, OH₂, and H₃O are not taken into the transparent conductive film.

When the alkali tungsten bronze contained in the transparent conductive film according to the present embodiment has a structure that exhibits a pattern of a hexagonal crystal as a powder X-ray diffraction pattern and is free of shift to an orthorhombic crystal, a trigonal crystal, and a pyrochlore phase, the alkali tungsten bronze assumes the pristine hexagonal tungsten bronze structure originally intended. As a result, it can produce free electrons and serve as a transparent conductive film having excellent conductivity.

The transparent conductive film according to the present embodiment may be formed of the alkali tungsten bronze. However, even in this case, this does not exclude the transparent conductive film according to the present embodiment containing unavoidable impurities due to a production process.

It is preferable that the alkali tungsten bronze of the transparent conductive film according to the present embodiment has a powder X-ray diffraction pattern that is free of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of a hexagonal crystal.

Because the extra peaks typically become superimposed on peaks of hexagonal alkali tungsten bronze, it is preferable to analyze peaks after peaks are decomposed.

"Free of extra peaks" means free of peaks attributable to, for example, (252)_{O}, (082)_{O}, (232)_{O}, (024)_{R}/(1,1,18)_{R}, (0,2,10)_{R}/(0,1,32)_{R}, (202)_{R}, (0,0,36)_{R}, (311)_{P}, and (222)_{P} already mentioned, as will be revealed after peaks are decomposed.

The transparent conductive film according to the present embodiment may contain a trace heterogenous phase so long as it does not exceed a range beyond which the transparent conductive film cannot exhibit excellent conductivity. Hence, the criterion for determining extra peaks is not particularly limited. For example, when the intensity of the peak from (20-20)_{H}, which is the maximum-intensity peak of a hexagonal alkali tungsten bronze, is assumed to be 1, it may be determined that the hexagonal alkali tungsten bronze is free of the extra peaks when maximum-intensity peaks attributable to an orthorhombic crystal, a trigonal peak, and a pyrochlore phase have an intensity of 0.25 or lower.

It is preferable that the alkali tungsten bronze contained in the transparent conductive film according to the present embodiment is represented by general formula: AₓW_{y}O_{z} (where 0.2≤x/y≤0.5, 2.5≤z/y≤3.0, and the element A is one or more alkali metal elements selected from K, Rb, and Cs) .

The element A may be partially replaced by an element other than an alkali metal element. Hence, the alkali tungsten bronze contained in the transparent conductive film according to the present embodiment may be represented by general formula: AₓW_{y}O_{z} (where 0.2≤x/y≤0.5, 2.5≤z/y≤3.0, and the element A is one or more alkali metal elements selected from K, Rb, and Cs), and the element A may be partially replaced by one or more elements selected from Na, Tl, In, Li, Be, Mg, Ca, Sr, Ba, Al, and Ga. When the alkali tungsten bronze is replaced by the mentioned replacing element, which is assumed to be a replacing element M, the alkali tungsten bronze contained in the transparent conductive film according to the present embodiment may also be represented by general formula: Aₓ₋ₐMₐW_{y}O_{z}. In the general formula above, M represents the replacing element M, a represents an amount by which the element A is replaced by the replacing element M, where the amount satisfies 0≤a<x. Description of the element A, and x, y, and z will be omitted, because they have already been described. The degree to which or the ratio at which the element A is replaced by the replacing element is not particularly limited, and may be desirably selected depending on, for example, required properties.

The lattice constants of the alkali tungsten bronze contained in the transparent conductive film according to the present embodiment are not particularly limited. It is preferable that the lattice constant of the c-axis of a hexagonal crystal is 7.54 Å or less when the element A is K, 7.58 Å or less when the element A is Rb, and 7.64 Å or less when the element A is Cs. Particularly, it is more preferable that the lattice constant of the c-axis of a hexagonal crystal is 7.49 Å or greater and 7.54 Å or less when the element A is K, 7.51 Å or greater and 7.58 Å or less when the element A is Rb, and 7.56 Å or greater and 7.64 Å or less when the element A is Cs.

When the lattice constant of the alkali tungsten bronze is in the range specified above, it is more secure that the alkali tungsten bronze be a hexagonal crystal, which means that it is free of shift to an orthorhombic crystal, a trigonal crystal, and a pyrochlore phase described above.

The film thickness of the transparent conductive film according to the present embodiment is not particularly limited, yet is preferably 30 nm or greater and 1,200 nm or less. As described below, the transparent conductive film according to the present embodiment is a film obtained by, for example, sputtering film formation. Therefore, it is unnecessary to use a dispersant or a medium resin, and the film can be formed thinly and uniformly.

When the film thickness of the transparent conductive film according to the present embodiment is 30 nm or greater, the transparent conductive film can have a particularly low resistance value.

When the film thickness of the transparent conductive film according to the present embodiment is 1,200 nm or less, coloration of the film can be inhibited, and it is possible to save the amount by which the target is consumed during production, to save the time taken for sputter film formation, and to increase productivity.

The specific resistance value of the transparent conductive film according to the present embodiment is preferably, for example, 1.0×10⁻² Qcm or lower, and more preferably 5.0×10⁻³ Qcm or lower.

The visible light transmittance through the transparent conductive film according to the present embodiment is preferably 50% or higher.

### [Method for producing transparent conductive film]

Next, one configuration example of a method for producing a transparent conductive film according to the present embodiment will be described. The method for producing a transparent conductive film according to the present embodiment can produce the transparent conductive film described above. Hence, description of some of the particulars already described will be omitted.

The method for producing a transparent conductive film according to the present embodiment may include a film formation step and a thermal treatment step described below.

In the film formation step, a thermally untreated film containing the elements constituting the alkali tungsten bronze can be formed on a surface of a base material.

In the thermal treatment step, the thermally untreated film can be thermally treated.

It is preferable to perform the film formation step under a film formation condition under which water does not intrude the interior of the thermally untreated film.

Each step will be described below.

### (1) Film formation step

### (1-1) Raw materials and targets

In the film formation step, it is possible to form the thermally untreated film by, for example, a dry method. As the raw materials used for forming a thermally untreated film in the film formation step, for example, a tungsten source and an alkali metal element source that can constitute the alkali tungsten bronze may be used. As the raw materials, a complex tungsten oxide having a specific composition may optionally be used.

As the tungsten source, one or more selected from tungsten and tungsten compounds may be used.

As the alkali metal element source, one or more selected from compounds of alkali metal elements, and hydrates of compounds of alkali metal elements may be used.

For example, tungstic acid (H₂WO₄) is one of the raw materials of tungsten sources commonly used. A tungsten trioxide powder obtained by burning tungstic acid may be used as the raw material of the tungsten source, or a commercially available product of a tungsten trioxide powder may be used.

As the tungsten source, tungsten oxide or a complex tungsten oxide may optionally be used. As the tungsten oxide, a tungsten oxide powder represented by W_{y}O_{z} (where W represents tungsten, O represents oxygen, and 2.2≤z/y≤3.0) may be used. As the complex tungsten oxide, for example, a complex tungsten oxide powder represented by general formula: AₓW_{y}O_{z} (where A represents the mentioned element A, W represents tungsten, O represents oxygen, 0.001≤x/y≤1, and 2.2≤z/y≤3.0) may be used.

As the raw material to be used for forming the thermally untreated film, it is preferable to use, for example, a raw material in which a tungsten source and an alkali metal element source are mixed such that a formed thermally untreated film will have an intended composition.

As the raw material, it is possible to use, for example, a mixture powder obtained by mixing tungstic acid (H₂WO₄) with one or more selected from oxides and hydroxides of alkali metal elements, or a mixture powder obtained by mixing tungsten trioxide with one or more selected from oxides and hydroxides of alkali metal elements. Moreover, it is possible to use a powder of a product obtained by burning in an atmosphere of an inert gas or a mixture gas of an inert gas and a reducing gas, a mixture powder obtained by mixing a mixture of tungstic acid (H₂WO₄) and tungsten trioxide particles with one or more selected from oxides and hydroxides of alkali metal elements, or a dry powder obtained by mixing one or more selected from tungstic acid (H₂WO₄) and tungsten trioxide particles with one or more selected from aqueous solutions of metal salts of alkali metal elements, metal oxide colloid solutions, and alkoxy solutions, and drying the mixture. When using the dry powder obtained by mixing one or more selected from tungstic acid (H₂WO₄) and tungsten trioxide particles with one or more selected from aqueous solutions of metal salts of alkali metal elements, metal oxide colloid solutions, and alkoxy solutions, and drying the mixture, the partner ion to form a salt is not particularly limited, and examples of the ion include nitrate ion, sulfate ion, chloride ion, and carbonate ion. The drying temperature and time are not particularly limited.

When using complex tungsten oxide represented by general formula: AₓW_{y}O_{z} as the raw material to be used for forming the thermally untreated film, one or more alkali metal elements selected from K, Rb, and Cs may be used as the element A as described above. Here, the element A may be partially replaced by one or more elements selected from Na, Tl, In, Li, Be, Mg, Ca, Sr, Ba, Al, and Ga.

It is possible to form the thermally untreated film by, for example, using a pellet obtained by molding the raw material described above, or a target obtained by sintering the raw material described above.

As the method for forming the thermally untreated film in the film formation step, film formation by vacuum vapor deposition or film formation by sputtering is preferable. As the method for forming the thermally untreated film, film formation by a sputtering method using a sputtering target is more preferable. Particularly, a film formation method by direct-current sputtering in which a direct-current voltage is applied to the target is more preferable, because a power supply configuration is simple and productivity is excellent.

When forming the thermally untreated film by the sputtering method, the sputtering target may contain an alkali metal element and tungsten that are constituent elements of the alkali tungsten bronze.

In this case, it is preferable that the sputtering target is any selected from a sputtering target formed of alkali tungsten bronze, and a sputtering target formed of a precursor containing an alkali metal element and tungsten. For example, it is preferable to use a sputtering target that uses the raw materials described above.

When using a target formed of a sintered body of the alkali tungsten bronze, i.e., a sintered body of a complex alkali tungsten oxide as the sputtering target, the composition thereof is not particularly limited. However, an A/W ratio, which is a substance composition ratio of the element A (A) to the tungsten element (W) contained in the sputtering target is preferably 0.2 or greater and 0.7 or less and more preferably 0.2 or greater and 0.5 or less, because the composition ratio is reflected on a substance ratio A/W of the element A to the tungsten element contained in the thermally untreated film to be obtained. For example, a polytungstate target described in Patent Document 4 indicated above may be used. The crystal structure of the target is not particularly limited, because it does not directly affect the crystal structure of the film.

It is preferable that the sputtering target has a relative density of 70% or higher and a specific resistance of 1 Ω•cm or lower. It is possible to produce such a sputtering target by, for example, sintering a complex tungsten oxide powder by hot press in a vacuum or in an inert atmosphere. A sintered body produced in this manner has a strength that can endure mechanical processing during the target production and a brazing temperature during bonding, and has a conductivity that allows direct-current sputtering.

The method for forming the thermally untreated film is not limited to use of the complex tungsten oxide sintered body as the target. For example, the thermally untreated film may be formed by a co-sputtering method that uses an AₓO_{z} target, which is an alkali metal element oxide, and a W_{y}O_{z} target, which is tungsten oxide. For example, by adjusting the power applied for sputtering such that the A/W ratio, which is the substance composition ratio of the element A (A) to the tungsten element (W) in the thermally untreated film to be obtained, becomes 0.2 or greater and 0.7 or less, it is possible to obtain a thermally untreated film that is similar to one that is obtained when a complex tungsten oxide target is used. The A/W ratio is preferably 0.2 or greater and 0.5 or less.

Depending on the method for producing the target, the target may have a poor conductivity, and direct-current sputtering using a direct-current power supply may be impossible. This can be overcome by using a pulse power supply, a Medium Frequency (MF) power supply, and a Radio Frequency (alternating-current wave) power supply.

### (1-2) Operations in the film formation step

The base material (substrate) on which the thermally untreated film is formed is not particularly limited, but glass is preferable because glass is transparent with respect to the visible light range and does not easily deteriorate or deform in the next thermal treatment step. When using glass as the base material, the thickness of the glass is preferably 0.1 mm or greater and 10 mm or less. However, the thickness of the glass is not particularly limited so long as it is a thickness commonly employed, for example, as window glass for construction or glass for automobiles, or in display devices.

As a sputtering apparatus used in the film formation step, it is preferable to use a load lock-type sputtering apparatus in order to inhibit to the extent possible, mixing of water into a sputter-formed film, which is the thermally untreated film. For gas evacuation from the sputtering apparatus, a turbomolecular pump may be used. In order to evacuate water more efficiently, it is preferable to further add a water aggregation and evacuation means such as a cryocoil and a cryopanel.

In the film formation step, it is preferable to form the thermally untreated film under a film formation condition under which no water intrudes the interior of the thermally untreated film.

Specifically, during formation of the thermally untreated film, it is preferable that the water pressure in the chamber is lower than 1×10⁻⁴ Pa. The water pressure here means the water pressure in an atmosphere after the gas evacuation from the chamber and immediately before introduction of a sputtering gas for forming the thermally untreated film.

In the film formation step, it is preferable that the ultimate vacuum in the chamber in which the thermally untreated film is to be formed is lower than 1×10⁻⁴ Pa. The ultimate vacuum here means the ultimate vacuum after the gas evacuation from the chamber and immediately before introduction of a sputtering gas for forming the thermally untreated film.

In order to achieve the water pressure and the ultimate vacuum specified, it is preferable to evacuate gases using, for example, the turbomolecular pump mentioned above while, for example, heating the inside of the chamber, after setting the target and the base material in the chamber. It is also possible to previously reduce water adhering to surfaces inside the chamber by purging the water by a gas such as a nitrogen gas while heating the inside of the chamber, before setting the target and the base material in the chamber (preparatory heating and degasification). Then, after a sufficient ultimate vacuum is reached inside the chamber, a sputtering gas may be supplied into the chamber.

In order to remove water adhering to the target, gas evacuation may be performed inside the chamber again as needed, after dummy sputtering is performed in a state that a shutter between the base material and the target is closed. In this case, it is also preferable that the water pressure and the ultimate vacuum specified above are satisfied through the gas evacuation performed after the dummy sputtering. Then, after the gas evacuation, it is preferable to supply a sputtering gas into the chamber and perform film formation.

Hence, before performing film formation in the film formation step, it is preferable to perform a water removing step for removing water from inside the chamber.

In the water removing step, specifically, for example, a preparatory heating and degasification step of purging water inside the chamber by, for example, an inert gas, a first gas evacuation step of evacuating gases from inside the chamber after the target and the base material are set inside the chamber, and a first sputtering gas supplying step of supplying a sputtering gas into the chamber may be performed.

In the water removing step, after the first sputtering gas supplying step, a dummy sputtering step of performing dummy sputtering, and a second gas evacuation step of evacuating gases from inside the chamber again may be performed as needed. Then, after a second sputtering gas supplying step of supplying a sputtering gas into the chamber is performed after the second gas evacuation step, it is preferable to perform the film formation step of forming the thermally untreated film on the surface of the base material.

In both of the first gas evacuation step and the second gas evacuation step, it is preferable that the ultimate vacuum reaches a level lower than 1×10⁻⁴ Pa.

The sputtering gas used for forming the thermally untreated film is not particularly limited. For example, it is preferable to use an argon gas, or a mixture gas of an argon gas and oxygen. A nitrogen gas may be used instead of an argon gas. However, it is more preferable to use an argon gas.

Whether to use an argon gas or to use a mixture gas of an argon gas and an oxygen gas when forming the thermally untreated film is related to the next thermal treatment step.

In a case of using a mixture gas when forming the thermally untreated film, a mixture gas in which the oxygen concentration is high may reduce the film formation rate and reduce the productivity. Hence, the oxygen concentration in the mixture gas is preferably lower than 20% by volume, and more preferably 3% by volume or higher and 10% by volume or lower. The optimum oxygen concentration may be selected depending on the film formation conditions because the optimum oxygen concentration is significantly dependent on the period of time for which oxygen is taken into the thermally untreated film, which is a sputter-formed film, i.e., the film formation rate.

It is preferable that the purity of the sputtering gas that is used in the film formation step, i.e., that is supplied in the second sputtering gas supplying step is high. The sputtering gas purity is preferably 3 N or higher, more preferably 4 N or higher, and yet more preferably 5 N or higher. By increasing the purity of the sputtering gas, it is possible to suppress the water pressure inside the chamber and inhibit mixing of impurities such as water into the thermally untreated film in the film formation step.

When performing the dummy sputtering step as described above, it is preferable that the purity of the sputtering gas in the dummy sputtering step, i.e., the sputtering gas supplied in the first sputtering gas supplying step is also high. The sputtering gas purity is preferably 3 N or higher, more preferably 4 N or higher, and yet more preferably 5 N or higher.

When using an argon gas as the sputtering gas, it is preferable that the argon gas purity is 99.9% or higher, the oxygen concentration is lower than 0.1%, and the hydrogen concentration is lower than 1 ppm. It is more preferable that the argon gas purity is 99.999% or higher, the oxygen concentration is lower than 0.2 ppm, and the hydrogen concentration is lower than 0.5 ppm.

A film that is sputter-formed at normal temperature without heating the substrate is typically amorphous. However, it does not matter if the amorphous film has a diffraction peak attributable to a crystal when analyzed by X-ray diffractometry, because formation of a hexagonal crystal structure is performed afresh in the following thermal treatment step.

### (2) Thermal treatment step

Next, in the thermal treatment step, it is possible to form a hexagonal crystal structure by thermally treating the thermally untreated film obtained in the film formation step. In the thermal treatment step, it is possible to thermally treat the thermally untreated film at 400°C or higher and lower than 1,000°C in an atmosphere selected depending on the oxygen content in the thermally untreated film, specifically, any selected from an inert atmosphere, a reducing atmosphere, and an oxidative atmosphere.

Goals of the thermal treatment may be, for example, to form a hexagonal crystal and to reduce octahedral oxygen. Therefore, in the thermal treatment step, the thermally untreated film may be thermally treated at, for example, 400°C or higher and lower than 1,000°C in, for example, an inert atmosphere or a reducing atmosphere. By thermally treating the thermally untreated film obtained in the film formation step, it is possible to form an alkali tungsten bronze having a hexagonal crystal structure having a high crystallinity.

In the thermal treatment step, it is preferable to perform the thermal treatment by selecting the atmosphere depending on the gas in the sputtering film formation such that the oxygen concentration in the film to be obtained falls within an appropriate range. Either the film formation step or the thermal treatment step may be performed in an atmosphere containing oxygen.

In a case where the film formation is performed in the film formation step by using a mixture gas of argon and oxygen as the sputtering gas, it is preferable to thermally treat the thermally untreated film in the thermal treatment step at a temperature of 400°C or higher and lower than 1,000°C, more preferably at a temperature of 400°C or higher and 950°C or lower in an inert gas atmosphere or a reducing atmosphere. As the inert gas atmosphere or the reducing atmosphere, for example, a nitrogen gas, an argon gas, a mixture gas of hydrogen and nitrogen, and a mixture gas of hydrogen and argon may be used.

In the case where the film formation step is performed in an atmosphere containing oxygen, the thermal treatment in the thermal treatment step may excessively oxidize the thermally untreated film, if performed in an oxidative atmosphere such as air and oxygen. As a result, oxygen vacancies decrease in the alkali tungsten bronze contained in the film to be obtained, to change the crystal structure to an orthorhombic crystal containing numerous W defects and alkali metal element defects such as Cs defects, and to a conduction electron-deficient insulator having a poor conductivity.

It is preferable that the thermal treatment temperature is 400°C or higher and lower than 1,000°C as described above. By setting the thermal treatment temperature to 400°C or higher, it is possible to crystallize the alkali tungsten bronze contained in the transparent conductive film and to inhibit various types of defects. Hence, the transparent conductive film can have an appropriate electronic structure and a particularly good conductivity.

By setting the thermal treatment temperature to lower than 1,000°C, it is possible to inhibit the transparent conductive film and the base material from reacting with each other, and to inhibit, for example, deformation of the base material, and peeling of the transparent conductive film.

Because formation of a hexagonal crystal and reduction of oxygen progress smoothly, the thermal treatment time may be, for example, 10 minutes or longer and 60 minutes or shorter, although not particularly limited.

In the meantime, in a case where film formation is performed in the film formation step by using only an argon gas as the sputtering gas, it is considered that the oxygen concentration in the thermally untreated film is at or under an appropriate level.

Hence, in the thermal treatment step, conductivity can be obtained even if the thermal treatment is performed in an oxygen-free inert gas such as a nitrogen gas. Through the thermal treatment in an oxygen-free inert gas such as a nitrogen gas, conductivity can be obtained in a broad temperature range. Moreover, in this case, the thermal treatment may be performed in the thermal treatment step in an oxygen-containing oxidative atmosphere. Thermal treatment performed in an oxygen-containing oxidative atmosphere can maintain the oxygen concentration in the film in a more appropriate range and can better increase conductivity.

Hence, in this case, it is preferable to perform the thermal treatment in the thermal treatment step using air or an atmosphere in which the oxygen concentration is 5% by volume or higher and 20% by volume or lower as the thermal treatment atmosphere.

The thermal treatment furnace in a case of the thermal treatment atmosphere being an air atmosphere need not be a special tightly-closed structure. The thermal treatment temperature is preferably 400°C or higher and lower than 1,000°C, and more preferably 400°C or higher and 950°C or lower.

By setting the thermal treatment temperature to 400°C or higher, it is possible to crystallize the alkali tungsten bronze contained in the transparent conductive film sufficiently and to inhibit various types of defects. Hence, the transparent conductive film can have an appropriate electronic structure and a particularly good conductivity.

By setting the thermal treatment temperature to lower than 1,000°C, it is possible to inhibit excessive oxidization and to obtain a transparent conductive film having a particularly good conductivity. Moreover, it is possible to inhibit the transparent conductive film and the base material from reacting with each other, and to inhibit, for example, deformation of the base material, and peeling of the transparent conductive film.

The thermal treatment time may be, for example, 10 minutes or longer and 60 minutes or shorter, although not particularly limited.

In a case where, for example, a resin substrate that cannot endure the thermal treatment step at 400°C or higher is used as the base material, it may be possible to obtain an effect similar to that of the thermal treatment, by performing sputter film formation at normal temperature, together with irradiating the substrate, which is under the sputtering, with ion beams or plasma, because this may promote crystallization by the impinging energy of the ions.

### [Transparent conductive member, electronic display device, and solar battery]

A transparent conductive member according to the present embodiment may include a base material, and the transparent conductive film described above, which is provided on the surface of the base material.

Because the transparent conductive film described above has excellent conductivity, it can be used for various purposes of use, such as a transparent electrode for a display and a transparent electrode for a solar battery.

Accordingly, an electronic display device including the transparent conductive member according to the present embodiment, and a solar battery including the transparent conductive member according to the present embodiment can be obtained.

### EXAMPLES

Specific Examples will be given below to proceed with the following description. The present invention should not be construed as being limited to these Examples.

### (1) Evaluation method

### (1-1) Specific resistance

The specific resistance of a film was measured using LORESTA-GX and HIRESTA-UX obtained from Mitsubishi Chemical Corporation.

### (1-2) Film thickness

The film thickness was measured using a step gauge (ALPHA-STEP IQ obtained from KLA-Tencor Japan Ltd.).

### (1-3) Powder X-ray diffraction pattern measurement, and lattice constant

A powder X-ray diffraction pattern (XRD pattern) of an obtained film was measured using a D2 PHASER X-ray diffractometer obtained From BRUKER AXS GmbH) using a Cu-Kα ray.

A lattice constant of a crystal phase is obtained using calculation software DIFFRAC TOPAS obtained from BRUKER AXS GmbH according to a Pawley method assuming a space group P6₃/mcm.

### (1-4) Visible light transmittance, solar radiation transmittance, and near-infrared reflectance

As optical properties of an obtained film, transmittance and 8° incidence diffuse reflectance were measured using a spectrophotometer V-670 (obtained from JASCO Corp.).

Using spectroscopic data regarding transmittance of reflectance, visible light transmittance (VLT) and transmittance (ST25) of solar radiation of 300 nm or longer and 2,500 nm or shorter were obtained according to Japanese Industrial Standard (JIS) R 3106 (2019). Reflectance (η) of near-infrared rays of 780 nm or longer and 2,500 nm or shorter was calculated according to JIS K 5602 (2008).

### (1-5) Composition

The composition of the alkali tungsten bronze in an obtained film was obtained by a chemical analysis. An alkali metal element, and tungsten were analyzed using an ICP emission spectroscopic analyzer (obtained from Shimadzu Corporation, Model No. ICPE-9000). Oxygen was analyzed by melting a sample in a He gas using a light element analyzer (obtained from LECO Corporation, Model No. ON-836), and measuring a CO gas produced through a reaction of the sample with carbon of an analytical crucible according to an IR absorption spectroscopy.

### [Example 1]

### (Target producing step)

A cesium carbonate aqueous solution and a tungsten trioxide hydrate were mixed and kneaded at a ratio at which the substance ratio Cs/W between cesium (Cs) and tungsten (W) would be 0.35, and dried at 100°C for 12 h in open air, to produce a precursor.

The precursor was subjected to raising temperature to 800°C in an airflow containing 5% by volume of H₂ and 95% by volume of N₂, retained in the state for 1 hour, and gradually cooled to room temperature. As a result, a dark blue complex tungsten oxide powder (hereinafter, referred to as CsWO powder) was obtained.

The CsWO powder was fed into a hot press apparatus, and sintered in a vacuum atmosphere at a temperature of 950°C at a pressing pressure of 250 kgf/cm², to produce a CsWO sintered body. The composition of the sintered body was chemically analyzed, and a substance ratio Cs/W between Cs and W turned out to be 0.32. This oxide sintered body was polished to a diameter of 153 mm and a thickness of 5 mm by machine processing, and bonded to a stainless steel backing plate using a metal indium brazing material, to produce a CsWO target.

### (Film formation step)

In the film formation step, a sputtering apparatus (obtained from Ulvac, Inc., Model No. SBH2306) was used. The chamber of the sputtering apparatus was openable or closable by a load lock manner, and a turbomolecular pump was used to evacuate gases from inside the chamber. First, in order to inhibit water molecules from adsorbing to the inner walls of the chamber to an extent possible during venting of the sputtering apparatus, warm water of 60°C was introduced into water-cooled tubes that were run over the entirety of the external walls of the chamber to warm the external walls, and then the chamber was subsequently vented along with water evacuation by introduction of a nitrogen gas into the chamber (preparatory heating and degasification).

Next, the CsWO target described above, and a Ti target were attached in the sputtering apparatus. A glass substrate (EXG obtained from Corning Incorporated, having a thickness of 0.7 mm) was attached in the sputtering apparatus. After the chamber was closed, gas evacuation was performed using a dry pump, turbo-molecules, and a cryocoil (water aggregation) until the ultimate vacuum in the chamber was on the order of 10⁻³ Pa. Subsequently, with a sheath heater and a substrate heater in the chamber maintained at 300°C, gas evacuation was performed until the ultimate vacuum was on the order of 10⁻⁵ Pa.

Then, with a shutter between the glass substrate and the targets closed, dummy sputter was performed for 20 minutes in order to remove residual water in the chamber, using a 5 N pure argon gas and by application of a direct current of 600 W to the Ti target.

Moreover, with the shutter between the glass substrate and the targets closed, dummy sputter was performed for 20 minutes in order to remove water adsorbing to anywhere near the surface of the CsWO target using a 5 N pure argon gas and by application of a direct current of 600 W to the CsWO target.

Subsequently, gas evacuation was performed until the water pressure in the chamber became 2.0×10⁻⁵ Pa. The ultimate vacuum here is presented in Table 1. Then, using a 5 N-purity mixture gas of 5% by volume of oxygen and 95% by volume of argon and with the shutter between the glass substrate and the targets opened, a CsWO film was formed to a thickness of 40 nm at a sputtering gas pressure of 0.6 Pa at a supplied direct-current power of 600 W. For measuring the water pressure, a quadrupole mass spectrometer was used.

### (Thermal treatment step).

This film was fed into a lamp heating furnace (obtained from Yonekura Mfg. Co., Ltd., Model No. HP-2-9), and thermally treated in an atmosphere of 3% by volume of H₂ and 97% by volume of N₂ at a temperature of 600°C for 30 minutes.

### (Evaluation)

The transparent conductive film obtained through the thermal treatment step was quantitatively analyzed by XPS. As a result, Cs : W : O was 7.76 : 24.19 : 68.05 (atomic ratio) (Cs/W=0.32).

As a result of measuring a powder X-ray diffraction pattern of the transparent conductive film obtained through the thermal treatment step, a single phase having diffraction peaks attributable to hexagonal Cs_{0.32}WO₃ was observed as illustrated in FIG. 1.

No shift from a hexagonal crystal pattern was observed in the powder X-ray diffraction pattern of the obtained transparent conductive film. That is, the obtained transparent conductive film contained alkali tungsten bronze, and the alkali tungsten bronze exhibited itself as a hexagonal crystal and exhibited no shift to an orthorhombic crystal, a trigonal crystal, and a pyrochlore phase in the powder X-ray diffraction pattern. Moreover, it was confirmed that the powder X-ray diffraction pattern of the alkali tungsten bronze was free of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of the hexagonal crystal.

As the lattice constants of the alkali tungsten bronze crystal phase contained in the obtained transparent conductive film, values of a=7.390 Å and c=7.626 Å were obtained.

The film thickness of the obtained transparent conductive film was 39.6 nm. As a result of measuring the surface resistance, a specific resistance value of 2.5×10⁻⁴ Qcm was obtained, and it was confirmed that the transparent conductive film had a high conductivity.

As a result of measuring spectroscopic properties of the transparent conductive film, transmittance of visible light in a principal visible light wavelength range of from 400 nm or longer and 780 nm or shorter was high, whereas a considerable near-infrared reflection was observed in a near-infrared range beyond a wavelength of 800 nm.

A near-infrared reflectance of 61.2% was obtained with respect to a visible light transmittance of 68.1%. Hence, the transparent conductive film was confirmed to have a metallic conductivity represented by a specific resistance value ρ of 1.0×10⁻² Qcm or lower while maintaining a sufficient transparency of VLT≥50% with respect to the visible light range, and to have a high heat ray-shielding performance by reflecting light in the near-infrared range.

The conditions under which the transparent conductive film was produced are presented in Table 1, and the evaluation results of the obtained transparent film are presented in Table 2.

**[Table 1]**

| | Raw material | Substrate | Ultimate vacuum (Pa) | Gas purity | Preparatory heating and degasification | Water pressure (Pa) during film formation | Dummy sputter | Thermal treatment step | |
|---|---|---|---|---|---|---|---|---|---|
| | | | | | | | | Thermal treatment temperature (°C) | Atmosphere |
| Ex. 1 | Cs_{0.35}WO₃ | Glass | 3.0×10⁻⁵ | 5 N | Present | 2.5×10⁻⁵ | Ti | 600 | 3% by volume H₂ |
| Ex. 2 | Cs_{0.45}WO₃ | Glass | 3.0×10⁻⁵ | 5 N | Present | 2.5×10⁻⁵ | Ti | 600 | 3% by volume H₂ |
| Ex. 3 | Cs_{0.30}WO₃ | Glass | 3.0×10⁻⁵ | 5 N | Present | 2.5×10⁻⁵ | Ti | 600 | 3% by volume H₂ |
| Ex. 4 | Cs_{0.33}WO₃ | Glass | 3.0×10⁻⁵ | 5 N | Present | 2.5×10⁻⁵ | Ti | 550 | 3% by volume H₂ |
| Ex. 5 | Cs_{0.33}WO₃ | Glass | 3.0×10⁻⁵ | 5 N | Present | 2.5×10⁻⁵ | Ti | 500 | 3% by volume H₂ |
| Ex. 6 | Rb_{0.33}WO₃ | Glass | 3.0×10⁻⁵ | 6 N | Present | 2.5×10⁻⁵ | Ti | 600 | 3% by volume H₂ |
| Ex. 7 | K_{0.33}WO₃ | Glass | 3.0×10⁻⁵ | 5 N | Present | 2.5×10⁻⁵ | Ti | 600 | 3% by volume H₂ |
| Comp. Ex. 1 | Cs_{0.33}WO₃ | Glass | 6.5×10⁻⁴ | 4 N | Absent | 5.0×10⁻⁴ | Absent | 600 | 3% by volume H₂ |
| Comp. Ex. 2 | Cs_{0.20}WO₃ | Glass | 5.0×10⁻⁴ | 4 N | Present | 4.0×10^{-,4} | Absent | 600 | 3% by volume H₂ |
| Comp. Ex. 3 | Cs_{0.33}WO₃ | Glass | 7.0×10⁻⁴ | 4 N | Absent | 6.0×10⁻⁴ | Absent | 600 | Open air |

**[Table 2]**

| | Analyzed composition (atomic %) | | | | | Film thickness (nm) | Shift from hexagonal crystal in XRD pattern | Lattice constant c-axis length (Å) | Specific resistance (Ωcm) | Visible light transmittance (%) | Solar radiation transmittance (%) | Near-infrared reflectance (%) |
|---|---|---|---|---|---|---|---|---|---|---|---|---|
| | Cs/R b/K | W | O | (Cs,Rb,K) /W | O/W | | | | | | | |
| Ex. 1 | 7.76 | 24.19 | 68.05 | 0.32 | 2.81 | 39.6 | Absent | 7.626 | 2.5×10⁻⁴ | 68.1 | 41.9 | 61.2 |
| Ex. 2 | 9.68 | 24.07 | 66.25 | 0.40 | 2.75 | 35.5 | Absent | 7.580 | 5.4×10⁻⁴ | 67.5 | 43.7 | 48.4 |
| Ex. 3 | 6.57 | 25.43 | 68.00 | 0.26 | 2.67 | 41.7 | Absent | 7.612 | 9.6×10⁻⁴ | 63.8 | 38.5 | 58.8 |
| Ex. 4 | 7.41 | 24.42 | 68.17 | 0.30 | 2.79 | 40.1 | Absent | 7.604 | 6.9×10⁻⁴ | 65.4 | 43.3 | 45.2 |
| Ex. 5 | 7.37 | 24.18 | 68.45 | 0.30 | 2.83 | 34.9 | Absent | 7.628 | 1.3×10⁻³ | 69.6 | 45.8 | 40.9 |
| Ex. 6 | 7.39 | 23.86 | 68.75 | 0.31 | 2.88 | 36.6 | Absent | 7.564 | 3.1×10⁻⁴ | 70.7 | 42.6 | 55.3 |
| Ex. 7 | 7.27 | 23.45 | 69.28 | 0.31 | 2.95 | 25.3 | Absent | 7.534 | 2.6×10⁻³ | 74.1 | 48.0 | 36.7 |
| Comp. Ex. 1 | 7.03 | 24.58 | 68.39 | 0.29 | 2.78 | 42.5 | Orthorhombic shift | 7.655 | 1.9×10⁴ | 69.7 | 46.3 | 10.9 |
| Comp. Ex. 2 | 4.03 | 24.28 | 71.69 | 0.17 | 2.95 | 40.6 | Orthorhombic shift | 7.651 | 4.6×10⁶ | 73.2 | 46.4 | 10.4 |
| Comp. Ex. 3 | 7.03 | 23.19 | 69.78 | 0.30 | 3.01 | 37.3 | Pyrochlore shift | 7.724 | 8.3×10⁶ | 62.5 | 33.8 | 8.6 |

### [Example 2]

In the target producing step, a dark blue CsWO powder and a CsWO target were produced in the same manner as in Example 1, except that a cesium carbonate aqueous solution and a tungsten trioxide hydrate were mixed and kneaded at a ratio at which a substance ratio between cesium (Cs) and tungsten (W) would be Cs/W=0.45.

Then, the film formation step and the thermal treatment step were performed in the same manner as in Example 1, except that the CsWO target thus obtained was used.

### (Evaluation)

As a result of quantitatively analyzing the transparent conductive film obtained through the thermal treatment step by XPS, Cs : W : O turned out to be 9.68 : 24.07 : 66.25 (atomic ratio) (Cs/W=0.40). That is, it was revealed that the transparent conductive film was a Cs-rich film.

No shift from a hexagonal crystal pattern was observed in the powder X-ray diffraction pattern of the obtained transparent conductive film. That is, the obtained transparent conductive film contained an alkali tungsten bronze, and the alkali tungsten bronze exhibited itself as a hexagonal crystal and exhibited no shift to an orthorhombic crystal, a trigonal crystal, and a pyrochlore phase in the powder X-ray diffraction pattern. Moreover, it was confirmed that the powder X-ray diffraction pattern of the alkali tungsten bronze was free of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of the hexagonal crystal.

As indicated in Table 2, it was revealed that the obtained transparent conductive film was a transparent conductive film having a transparency represented by a visible light transmittance of 67.5%, a metallic conductivity represented by a specific resistance value of 5.4×10⁻⁴ Ocm, and a heat ray-reflecting performance represented by a near infrared reflectance of 48.4%.

### [Example 3]

In the target producing step, a dark blue CsWO powder and a CsWO target were produced in the same manner as in Example 1, except that a cesium carbonate aqueous solution and a tungsten trioxide hydrate were mixed and kneaded at a ratio at which a substance ratio between cesium (Cs) and tungsten (W) would be Cs/W=0.30.

Then, the film formation step and the thermal treatment step were performed in the same manner as in Example 1, except that the CsWO target thus obtained was used.

### (Evaluation)

As a result of quantitatively analyzing the transparent conductive film obtained through the thermal treatment step by XPS, Cs : W : O turned out to be 6.57 : 25.43 : 68.00 (atomic ratio) (Cs/W=0.26).

No shift from a hexagonal crystal pattern was observed in the powder X-ray diffraction pattern of the obtained transparent conductive film. That is, the obtained transparent conductive film contained alkali tungsten bronze, and the alkali tungsten bronze exhibited itself as a hexagonal crystal and exhibited no shift to an orthorhombic crystal, a trigonal crystal, and a pyrochlore phase in the powder X-ray diffraction pattern. Moreover, it was confirmed that the powder X-ray diffraction pattern of the alkali tungsten bronze was free of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of the hexagonal crystal.

As indicated in Table 2, it was revealed that the obtained transparent conductive film was a transparent conductive film having a transparency represented by a visible light transmittance of 63.8%, a metallic conductivity represented by a specific resistance value of 9.6×10⁻⁴ Qcm, and a heat ray-reflecting performance represented by a near infrared reflectance of 58.8%.

### [Example 4]

In the target producing step, a CsWO powder and a CsWO target were produced in the same manner as in Example 1, except that a cesium carbonate aqueous solution and a tungsten trioxide hydrate were mixed and kneaded at a ratio at which a substance ratio between cesium (Cs) and tungsten (W) would be Cs/W=0.33. In the film formation step, the CsWO target thus obtained was used. In the thermal treatment step, thermal treatment was performed in an atmosphere of 3% by volume of H₂ and 97% by volume of N₂ at a temperature of 550°C for 30 minutes. A transparent conductive film was produced in the same manner as in Example 1 except the particulars specified above.

### (Evaluation)

As a result of quantitatively analyzing the transparent conductive film obtained through the thermal treatment step by XPS, Cs : W : O turned out to be 7.41 : 24.42 : 68.17 (atomic ratio) (Cs/W=0.30).

No shift from a hexagonal pattern was observed in the powder X-ray diffraction pattern of the obtained transparent conductive film. That is, the obtained transparent conductive film contained alkali tungsten bronze, and the alkali tungsten bronze exhibited itself as a hexagonal crystal and exhibited no shift to an orthorhombic crystal, a trigonal crystal, and a pyrochlore phase in the powder X-ray diffraction pattern. Moreover, it was confirmed that the powder X-ray diffraction pattern of the alkali tungsten bronze was free of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of the hexagonal crystal.

As indicated in Table 2, it was revealed that the obtained transparent conductive film was a transparent conductive film having a transparency represented by a visible light transmittance of 65.4%, a metallic conductivity represented by a specific resistance value of 6.9×10⁻⁴ Qcm, and a heat ray-reflecting performance represented by a near infrared reflectance of 45.2%.

### [Example 5]

A CsWO powder and a CsWO target were produced in the same manner as in Example 1, except that in the target producing step, a cesium carbonate aqueous solution and a tungsten trioxide hydrate were mixed and kneaded at a ratio at which a substance ratio between cesium (Cs) and tungsten (W) would be Cs/W=0.33. In the film formation step, the CsWO target thus obtained was used. In the thermal treatment step, thermal treatment was performed in an atmosphere containing 3% by volume of H₂ and 97% by volume of N₂ at a temperature of 500°C for 30 minutes. A transparent conductive film was produced in the same manner as in Example 1 except the particulars specified above.

### (Evaluation)

As a result of quantitatively analyzing the transparent conductive film obtained through the thermal treatment step by XPS, Cs : W : O turned out to be 7.37 : 24.18 : 68.45 (atomic ratio) (Cs/W=0.30).

No shift from a hexagonal crystal pattern was observed in the powder X-ray diffraction pattern of the obtained transparent conductive film. That is, the obtained transparent conductive film contained an alkali tungsten bronze, and the alkali tungsten bronze exhibited itself as a hexagonal crystal and exhibited no shift to an orthorhombic crystal, a trigonal crystal, and a pyrochlore phase in the powder X-ray diffraction pattern. Moreover, it was confirmed that the powder X-ray diffraction pattern of the alkali tungsten bronze was free of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of the hexagonal crystal.

As indicated in Table 2, it was revealed that the obtained transparent conductive film was a transparent conductive film having a transparency represented by a visible light transmittance of 69.6%, a metallic conductivity represented by a specific resistance value of 1.3×10⁻³ Ocm, and a heat ray-reflecting performance represented by a near infrared reflectance of 40.9%.

### [Example 6]

In the target producing step, the raw material composition was changed to Rb_{0.33}WO₃ (RbWO). A blue RbWO powder and a RbWO target were produced in the same manner as in Example 1, except this point.

Then, the film formation step and the thermal treatment step were performed in the same manner as in Example 1, except that the RbWO target thus obtained was used and the gas purity was as presented in Table 1.

### (Evaluation)

As a result of quantitatively analyzing the transparent conductive film obtained through the thermal treatment step by XPS, Rb : W : O turned out to be 7.39 : 23.86 : 68.75 (atomic ratio) (Rb/W=0.31).

No shift from a hexagonal crystal pattern was observed in the powder X-ray diffraction pattern of the obtained transparent conductive film. That is, the obtained transparent conductive film contained alkali tungsten bronze, and the alkali tungsten bronze exhibited itself as a hexagonal crystal and exhibited no shift to an orthorhombic crystal, a trigonal crystal, and a pyrochlore phase in the powder X-ray diffraction pattern. Moreover, it was confirmed that the powder X-ray diffraction pattern of the alkali tungsten bronze was free of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of the hexagonal crystal.

As indicated in Table 2, it was revealed that the obtained transparent conductive film was a transparent conductive film having a transparency represented by a visible light transmittance of 70.7%, a metallic conductivity represented by a specific resistance value of 3.1×10⁻⁴ Ocm, and a heat ray-reflecting performance represented by a near infrared reflectance of 55.3%.

### [Example 7]

In the target producing step, the raw material composition was changed to K_{0.33}WO₃ (KWO) . A sky blue KWO powder and a KWO target were produced in the same manner as in Example 1, except this point.

Then, the film formation step and the thermal treatment step were performed in the same manner as in Example 1, except that the KWO target thus obtained was used.

### (Evaluation)

As a result of quantitatively analyzing the transparent conductive film obtained through the thermal treatment step by XPS, K : W : O turned out to be 7.27 : 23.45 : 69.28 (atomic ratio) (K/W=0.31) .

No shift from a hexagonal crystal pattern was observed in the powder X-ray diffraction pattern of the obtained transparent conductive film. That is, the obtained transparent conductive film contained an alkali tungsten bronze, and the alkali tungsten bronze exhibited itself as a hexagonal crystal and exhibited no shift to an orthorhombic crystal, a trigonal crystal, and a pyrochlore phase in the powder X-ray diffraction pattern. Moreover, it was confirmed that the powder X-ray diffraction pattern of the alkali tungsten bronze was free of extra peaks attributable to an orthorhombic crystal, a trigonal crystal, and a pyrochlore phase at angles smaller than and angles larger than the angles corresponding to the peaks of diffraction from (10-12)_{H} and (20-20)_{H} of the hexagonal crystal.

As indicated in Table 2, it was revealed that the obtained transparent conductive film was a transparent conductive film having a transparency represented by a visible light transmittance of 74.1%, a metallic conductivity represented by a specific resistance value of 2.6×10⁻³ Ωcm, and a heat ray-reflecting performance represented by a near infrared reflectance of 36.7%.

### [Comparative Example 1]

In the target producing step, a cesium carbonate aqueous solution and a tungsten trioxide hydrate were mixed and kneaded at a ratio at which a substance ratio between cesium (Cs) and tungsten (W) would be Cs/W=0.33. In the film formation step, the CsWO target thus obtained was used.

The film formation step was performed by a typical sputter film formation method by excluding measures taken in Example 1 for removing water. A transparent conductive film was formed in the same manner as in Example 1, except this point.

That is, first, the sputtering apparatus was vented without preparatory warming of the water-cooled tubes on the external walls of the chamber of the sputtering apparatus by warm water. Next, without using a Ti target, only the CsWO target and a glass substrate (EXG obtained from Corning Incorporated, having a thickness of 0.7 mm) were attached in the sputtering apparatus, and then gas evacuation was performed at room temperature without warming by the sheath heater and the substrate heater inside the chamber. As a result, the ultimate vacuum stopped at 6.5×10⁻⁴ Pa and did not reach the order of 10⁻⁵ Pa.

Next, the water pressure inside the chamber measured without performing dummy sputter was 5.0×10⁻⁴ Pa. Then, using a 4 N-purity mixture gas of 5% by volume of oxygen and 95% by volume of argon and with the shutter between the glass substrate and the target opened, a CsWO film was formed to a thickness of 400 nm at a sputtering gas pressure of 0.6 Pa at a supplied direct-current power of 600 W.

Subsequently, the thermal treatment step was performed in the same manner as in Example 1.

### (Evaluation)

As a result of quantitatively analyzing the film obtained through the thermal treatment step by XPS, Cs : W : O turned out to be 7.03 : 24.58 : 68.39 (atomic ratio) (Cs/W=0.29).

A characteristic shift from a hexagonal crystal pattern to an orthorhombic crystal was observed in the powder X-ray diffraction pattern of the obtained film.

As indicated in Table 2, it was revealed that the obtained film was a near-infrared absorptive film having a transparency represented by a visible light transmittance of 69.7% and a low solar radiation transmittance of 46.3%, but could not be said to be a transparent conductive film because it did not have a metallic conductivity as clear from its order-of-magnitude-high specific resistance value of 1.9×10⁴ Ocm, and did not have infrared reflectiveness.

### [Comparative Example 2]

In the target producing step, a blue (dark blue) CsWO powder and a CsWO target were produced in the same manner as in Example 1, except that a cesium carbonate aqueous solution and a tungsten trioxide hydrate were mixed and kneaded at a ratio at which a substance ratio between cesium (Cs) and tungsten (W) would be Cs/W=0.20.

In the next film formation step, sputter film formation was performed by partially maintaining and partially excluding the measures taken in Example 1 for removing water.

That is, after warm water of 60°C was introduced into the water-cooled tubes that were run all over the external walls of the chamber of the sputtering apparatus (obtained from Ulvac, Inc., Model No. SBH2306) to warm the external walls, the chamber was vented along with water evacuation by introduction of a nitrogen gas into the chamber (preparatory heating and degasification).

Next, after the CsWO target and a glass substrate (EXG obtained from Corning Incorporated, having a thickness of 0.7 mm) were attached in the sputter and the chamber was closed, gas evacuation was performed to the order of 10⁻³ Pa using a dry pump, turbo-molecules and a cryocoil (water aggregation), and then gas evacuation was performed with the sheath heater and the substrate heater inside the chamber maintained at 300°C. As a result, the ultimate vacuum stopped at 5.0×10⁻⁴ Pa and did not reach the order of 10⁻⁵ Pa.

Next, the water pressure inside the chamber measured without performing dummy sputter was 4.0×10⁻⁴ Pa. Then, using a 4 N-purity mixture gas of 5% by volume of oxygen and 95% by volume of argon and with the shutter between the glass substrate and the target opened, a CsWO film was formed to a thickness of 400 nm at a sputtering gas pressure of 0.6 Pa at a supplied direct-current power of 600 W.

Subsequently, the thermal treatment step was performed in the same manner as in Example 1.

### (Evaluation)

As a result of quantitatively analyzing the transparent conductive film obtained through the thermal treatment step by XPS, Cs : W : O turned out to be 4.03 : 24.28 : 71.69 (atomic ratio) (Cs/W=0.17).

A characteristic shift from a hexagonal crystal pattern to an orthorhombic crystal was observed in the powder X-ray diffraction pattern of the obtained transparent conductive film.

As indicated in Table 2, it was revealed that the obtained transparent conductive film was a near-infrared absorptive film having a transparency represented by a visible light transmittance of 73.2% and a low solar radiation transmittance of 46.4%, but it did not have metallic conductivity and infrared reflectivity as clear from its low near-infrared reflectance of 10.4% and its order-of-magnitude-high specific resistance value of 4.6×10⁶ Qcm, and could not be said to be a transparent conductive film.

### [Comparative Example 3]

In the target producing step, a blue (dark blue) CsWO powder and a CsWO target were produced in the same manner as in Example 1, except that a cesium carbonate aqueous solution and a tungsten trioxide hydrate were mixed and kneaded at a ratio at which a substance ratio between cesium (Cs) and tungsten (W) would be Cs/W=0.33.

The next film formation step was performed by a typical sputter film formation method by excluding measures taken in Example 1 for removing water.

That is, the sputtering apparatus was vented without preparatory warming of the water-cooled tubes on the external walls of the chamber of the sputtering apparatus by warm water. Next, without using a Ti target, only the CsWO target and a glass substrate (EXG obtained from Corning Incorporated, having a thickness of 0.7 mm) were attached in the sputtering apparatus, and then gas evacuation was performed at room temperature without warming by the sheath heater and the substrate heater inside the chamber. As a result, the ultimate vacuum stopped at 7.0×10⁻⁴ Pa and did not reach the order of 10⁻⁵ Pa.

Next, the water pressure inside the chamber measured without performing dummy sputter was 6.0×10⁻⁴ Pa. Then, using a 4 N-purity mixture gas of 5% by volume of oxygen and 95% by volume of argon and with the shutter between the glass substrate and the target opened, a CsWO film was formed to a thickness of 400 nm at a sputtering gas pressure of 0.6 Pa at a supplied direct-current power of 600 W.

Subsequently, the thermal treatment step was performed in the same manner as in Example 1, except that it was performed in an open air atmosphere.

### (Evaluation)

As a result of quantitatively analyzing the transparent conductive film obtained through the thermal treatment step by XPS, Cs : W : O turned out to be 7.03 : 23.19 : 69.78 (atomic ratio) (Cs/W=0.30).

As illustrated in FIG. 2, a characteristic shift from a hexagonal crystal pattern to a pyrochlore phase was observed in the powder X-ray diffraction pattern of the obtained transparent conductive film.

It was revealed that the film was a near-infrared absorptive film having a transparency represented by a visible light transmittance of 62.5% and a low solar radiation transmittance of 33.8%, but it did not have metallic conductivity and infrared reflectivity as clear from its low near-infrared reflectance of 8.6% and its order-of-magnitude-high specific resistance value of 8.3×10⁶ Qcm, and could not be said to be a transparent conductive film

The present application claims priority to Japanese Patent Application No. 2021-047555 filed with the Japan Patent Office on March 22, 2021, and the entire contents of Japanese Patent Application No. 2021-047555 are incorporated herein by reference.

## Claims

1. A transparent conductive film, comprising:
an alkali tungsten bronze,
wherein the alkali tungsten bronze exhibits a pattern of a hexagonal crystal as powder X-ray diffraction pattern, and is free of shift to an orthorhombic crystal, a trigonal crystal, and a pyrochlore phase.

2. The transparent conductive film according to claim 1,
wherein the powder X-ray diffraction pattern of the alkali tungsten bronze is free of extra peaks attributable to an orthorhombic crystal, a trigonal crystal, and a pyrochlore phase at angles smaller than and angles larger than angles corresponding to peaks of diffraction from (10-12)_{H} and (20-20)_{H} of the hexagonal crystal.

3. The transparent conductive film according to claim 1 or 2,
wherein the alkali tungsten bronze is represented by general formula: AₓW_{y}O_{z} (where 0.2≤x/y≤0.5, 2.5≤z/y≤3.0, and an element A is one or more alkali metal elements selected from K, Rb, and Cs).

4. The transparent conductive film according to claim 3,
wherein a c-axis of the hexagonal crystal of the alkaline tungsten bronze has a lattice constant of 7.54 Å or less when the element A is K, 7.58 Å or less when the element A is Rb, and 7.64 Å or less when the element A is Cs.

5. The transparent conductive film according to any one of claims 1 to 3,
wherein the alkali tungsten bronze is represented by general formula: AₓW_{y}O_{z} (where 0.2≤x/y≤0.5, 2.5≤z/y≤3.0, and an element A is one or more alkali metal elements selected from K, Rb, and Cs), and
the element A is partially replaced by one or more elements selected from Na, Tl, In, Li, Be, Mg, Ca, Sr, Ba, Al, and Ga.

6. A method for producing a transparent conductive film, the method comprising:
a film formation step of forming a thermally untreated film containing elements constituting an alkali tungsten bronze on a surface of a base material; and
a thermal treatment step of thermally treating the thermally untreated film,
wherein the film formation step is performed under a film formation condition under which water does not intrude into an interior of the thermally untreated film.

7. The method for producing a transparent conductive film according to claim 6,
wherein the film formation step is film formation by a sputtering method using a sputtering target, and
the sputtering target contains an alkali metal element and tungsten that are constituent elements of the alkali tungsten bronze.

8. The method for producing a transparent conductive film according to claim 7,
wherein the sputtering target is any selected from a sputtering target formed of the alkali tungsten bronze and a sputtering target formed of a precursor containing the alkali metal element and tungsten.

9. The method for producing a transparent conductive film according to any one of claims 6 to 8,
wherein a water pressure during film formation in the film formation step is lower than 1×10⁻⁴ Pa.

10. The method for producing a transparent conductive film according to any one of claims 6 to 9,
wherein an ultimate vacuum in the film formation step is lower than 1×10⁻⁴ Pa.

11. The method for producing a transparent conductive film according to any one of claims 6 to 10,
wherein a sputtering gas purity in the film formation step is 5 N or higher.

12. The method for producing a transparent conductive film according to any one of claims 6 to 11,
wherein the thermal treatment step is performed in an inert atmosphere or a reducing atmosphere at a thermal treatment temperature of 400°C or higher and lower than 1,000°C.

13. A transparent conductive member, comprising:
a base material; and
the transparent conductive film of any one of claims 1 to 5, the transparent conductive film being provided on a surface of the base material.

14. An electronic display device, comprising:
the transparent conductive member of claim 13.

15. A solar battery, comprising: the transparent conductive member of claim 13.
